# EUROPEAN PATENT APPLICATION

(11) **EP 4 691 966 A1**
(43) Date of publication of application: **11.02.2026**
(21) Application number: 25190374.6
(22) Date of filing: 18.07.2025
(51) Int. Cl.: B81B 7/00

(54) **ELECTRONIC DEVICE INCLUDING A PACKAGE WITH A CAP COUPLED TO A SUBSTRATE WITH AN IMPROVED RESILIENCE TO THE DELAMINATION AND RELATED MANUFACTURING PROCESS**

(30) Priority: 08.08.2024 IT 202400018709
(71) Applicant: STMicroelectronics International N.V., 1228 Plan-les-Ouates, Geneva (CH)
(72) Inventor: GRITTI, Alex, 20871 Vimercate (MB) (IT); LOMBARDI, Gianfranco, 20018 Sedriano (MI) (IT)
(74) Representative: Studio Torta S.p.A.

(57) **Abstract**

Electronic device including: a support structure (2) including a substrate (20) of dielectric material, a top conductive structure (22), arranged above the substrate (20), and a bottom conductive structure (24), arranged below the substrate (20), the top conductive structure (22) including an annular region (25), the bottom conductive structure (24) including an array of contacts (30); a cap (4), which is coupled to the annular region (25) in such a way that the cap (4) and the support structure (2) delimit a cavity (10); and at least one semiconductive die (14), which is arranged in the cavity (10) and generates one or more electric output signals. The array of contacts (30) includes: signal contacts (30"), which receive corresponding electric output signals or electric signals generated outside the electronic device (1); and reference contacts (30'), which are set to a reference potential. The electronic device (1) further includes a plurality of reinforcement conductive vias (75), each of which extends through the substrate (20) and has ends fixed respectively to the annular region (25) and to a corresponding reference contact (30').

## Description

### Technical Field

The present invention relates to an electronic device including a package, which includes a cap coupled to a substrate and has an improved resistance to the delamination; furthermore, the present invention relates to the corresponding manufacturing process.

### Background

As is known, packages for electronic devices are available nowadays which include, each, a respective metal cap, which is coupled to a substrate so as to delimit a cavity having, arranged therein, for example, a first and a second semiconductive die having, formed therein, for example, a microelectromechanical (MEMS) device, which generates at least one electric detection signal indicative of a corresponding quantity, and a reading circuit, which is coupled to the microelectromechanical device so as to process the electric detection signal and generate at least one electric output signal, which is made available outside the package.

The coupling between the cap and the substrate may be obtained, for example, thanks to the use of a metal ring, which is arranged on the top surface of the substrate, while on the bottom surface of the substrate a so-called "land grid array" is present, i.e. a grid array of planar-type contacts known as "lands"; in this case, the cap may be welded or glued to the metal ring, in such a way that the cavity is hermetically closed; furthermore, the electric output signal is provided on one of the contacts. The cap provides an electromagnetic shielding, as well as mechanical protection.

Unfortunately, during the assembling operations of the package, a delamination of the metal ring may occur, i.e. a detachment of the metal ring from the substrate, with a resulting detachment of the cap from the substrate, for example due to thermal cycling performed during the assembling operations.

### Summary

The aim of the present invention is therefore to provide an electronic device capable of overcoming at least in part the drawbacks of the prior art.

According to the present invention, an electronic device and a manufacturing process are provided as defined in the attached claims.

### Brief Description of the Figures

For a better understanding of the present invention, embodiments thereof are now described, purely by way of nonlimiting example, with reference to the attached drawings, wherein:
- Figure 1 schematically shows a perspective view of an electronic device;
- Figure 2 schematically shows a perspective view of a portion of the electronic device shown in Figure 1;
- Figure 3 schematically shows a perspective view of the electronic device shown in Figures 1 and 2, with portions removed;
- Figure 4 schematically shows a further perspective view of the electronic device shown in Figures 1-3;
- Figure 5 schematically shows a cross-section (not to scale) of a part of the electronic device shown in Figures 1-4;
- Figure 6 schematically shows a further perspective view of the electronic device shown in Figures 1-5, with portions removed;
- Figure 7A schematically shows a perspective view of a portion of the electronic device shown in Figures 1-6;
- Figure 7B shows an enlargement of Figure 7A;
- Figure 8 schematically shows a perspective view of a part of the portion of the electronic device shown in Figures 7A and 7B;
- Figures 9A, 9B and 9C schematically show cross-sections (not to scale) of portions of the electronic device shown in the preceding Figures; and
- Figure 10 schematically shows a top view of a set of contacts.

### Description of Embodiments

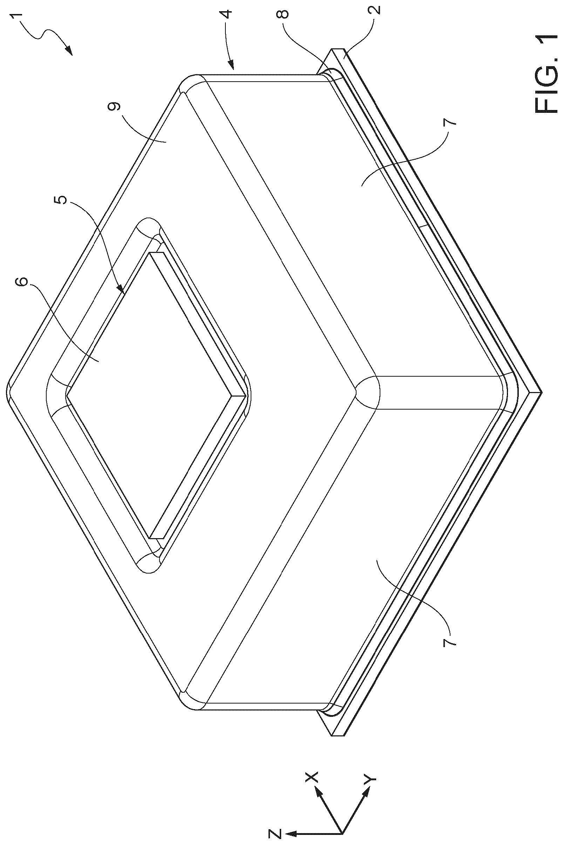

Figure 1 shows an orthogonal reference system XYZ and an electronic device 1, which is assumed hereinafter to be, purely by way of example, a so-called TMOS device, i.e. a thermal sensor manufactured with micromachining technologies and capable of detecting the presence/absence of hot bodies arranged in the surrounding environment.

The electronic device 1 comprises a support structure 2, a cap 4 of metal material (for example, brass or aluminum) and a lens 6.

The cap 4 has approximately the shape of a hollow parallelepiped and is coupled to the support structure 2 by means of a coupling region 8, which is for example a bonding (e.g., of the adhesive type) or welding region.

In practice, the cap 4 comprises four side walls 7 and a top wall 9, which is patterned so as to form a recess 5, having the lens 6 accommodated therein.

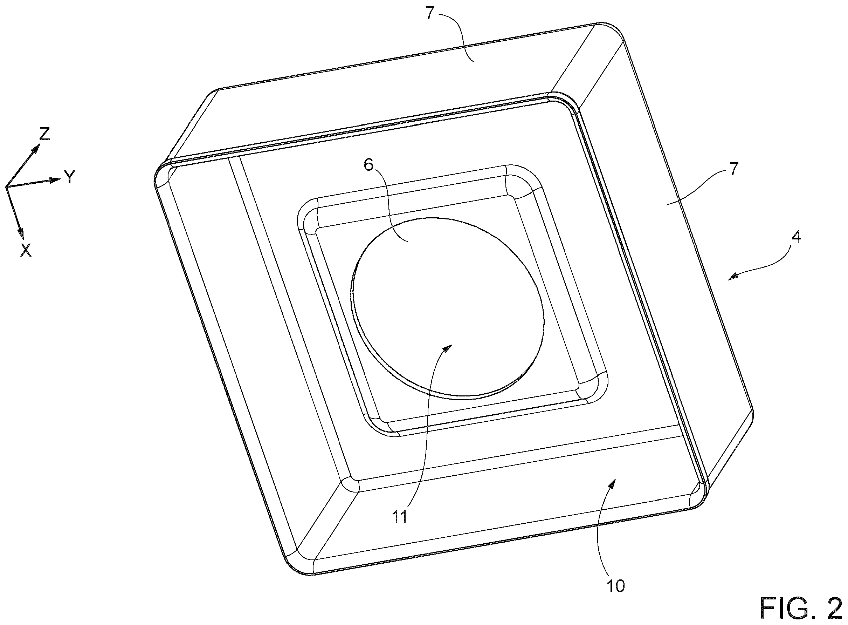

As shown in Figure 2, the cap 4 delimits laterally and upwardly a main cavity 10. Furthermore, the top wall 9 of the cap 4 is traversed by a hole 11, which faces the recess 5; the lens 6 is arranged above the hole 11, so as to collect the radiation coming from the outside of the electronic device 1 and focus it within the main cavity 10, through the hole 11.

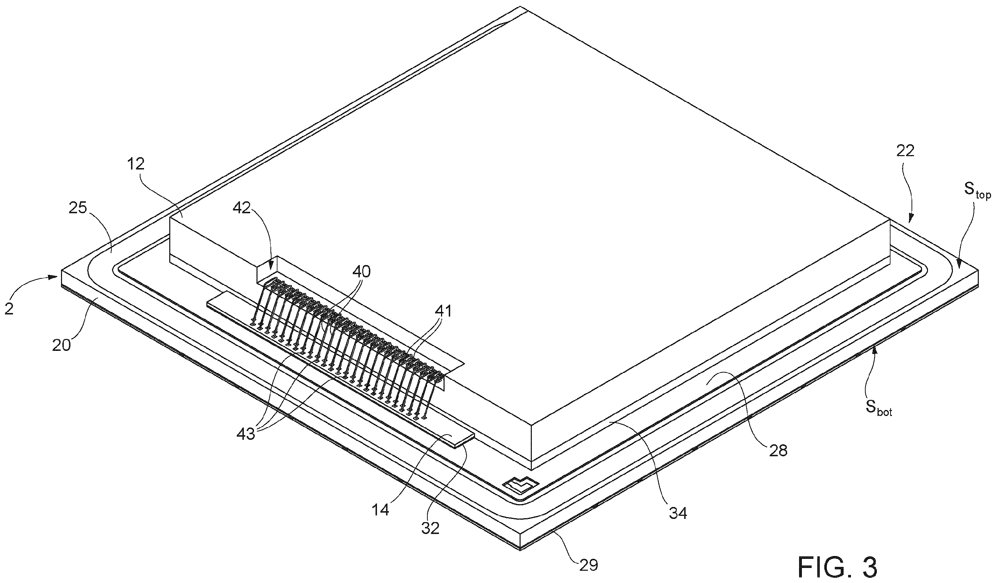

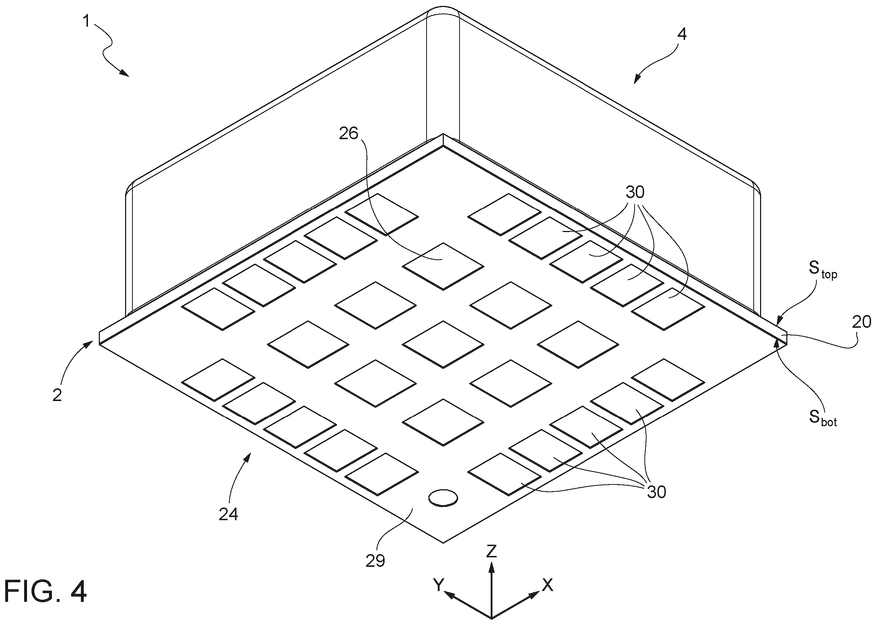

As shown in Figure 3, a first and a second semiconductive die 12, 14 are present within the main cavity 10. Furthermore, as shown again in Figure 3 and Figure 4, the support structure 2 comprises a dielectric substrate 20, which is formed for example by an organic dielectric material (for example, a so-called BT resin of bismaleimide-triazine, reinforced with glass fibers), has an approximately parallelepiped shape and is delimited by an top surface Sₜₒₚ and a bottom surface S_{bot} opposite to each other, which are parallel to the XY plane and have for example a rectangular or square shape. Furthermore, the support structure 2 comprises a top metallization 22 and a bottom metallization 24, which extend respectively above the top surface Sₜₒₚ and below the bottom surface S_{bot}.

The top metallization 22 comprises an annular region 25, which extends on the dielectric substrate 20, in direct contact, above the top surface Sₜₒₚ and has a planar shape, parallel to the XY plane.

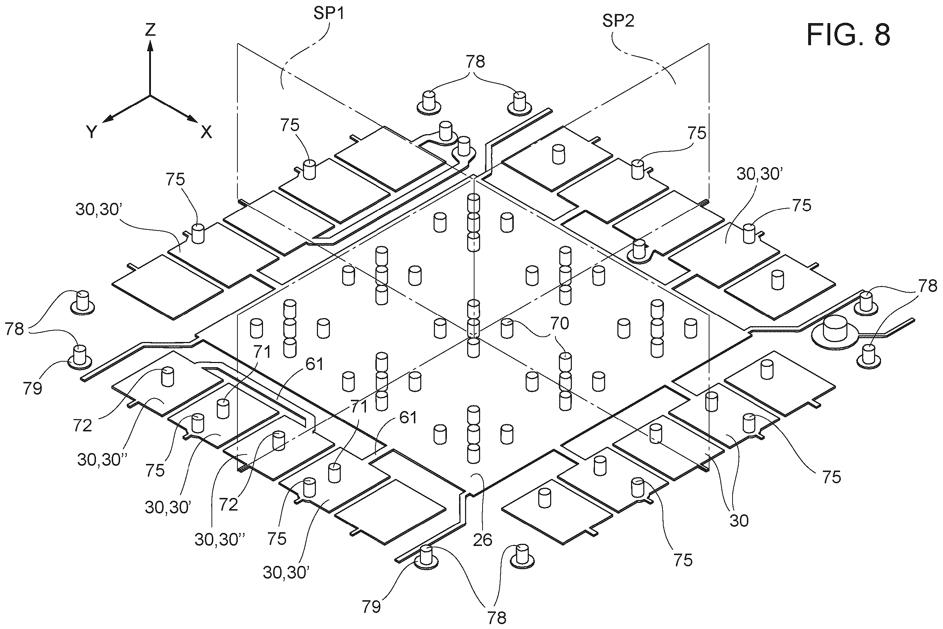

The bottom metallization 24 comprises a central region 26 (better visible in Figure 8), which extends below the bottom surface S_{bot} and has a planar shape parallel to the XY plane, for example rectangular; furthermore, the bottom metallization 24 comprises a plurality of peripheral contacts 30, which are "land" type contacts, i.e. they are contacts having an approximately rectangular shape, coplanar with the central region 26, therefore parallel to the XY plane.

Without any loss of generality, in the example shown, the peripheral contacts 30 are twenty in number and are arranged in four groups of five; in particular, in each group, the corresponding peripheral contacts 30 are arranged aligned parallel to a corresponding edge of the bottom surface S_{bot} of the dielectric substrate 20.

The support structure 2 also comprises a top mask region 28 (visible in Figure 3) and a bottom mask region 29 (visible in Figure 4), which are formed by dielectric material (e.g., a so-called solder mask resin).

In particular, the top mask region 28 extends above the top metallization 22, with which it is in direct contact, and above the portions of the top surface Sₜₒₚ left exposed by the top metallization 22, in direct contact; the bottom mask region 29 extends below the bottom metallization 24, with which it is in direct contact, and below the portions of the bottom surface S_{bot} left exposed by the bottom metallization 24, in direct contact.

As visible in Figure 4, the bottom mask region 29 is patterned, and in particular is provided with holes, in such a way as to expose the peripheral contacts 30. Furthermore, purely by way of example, the bottom mask region 29 is patterned in such a way as to expose nine portions of the central region 26, such nine portions being arranged so as to form a three-by-three matrix.

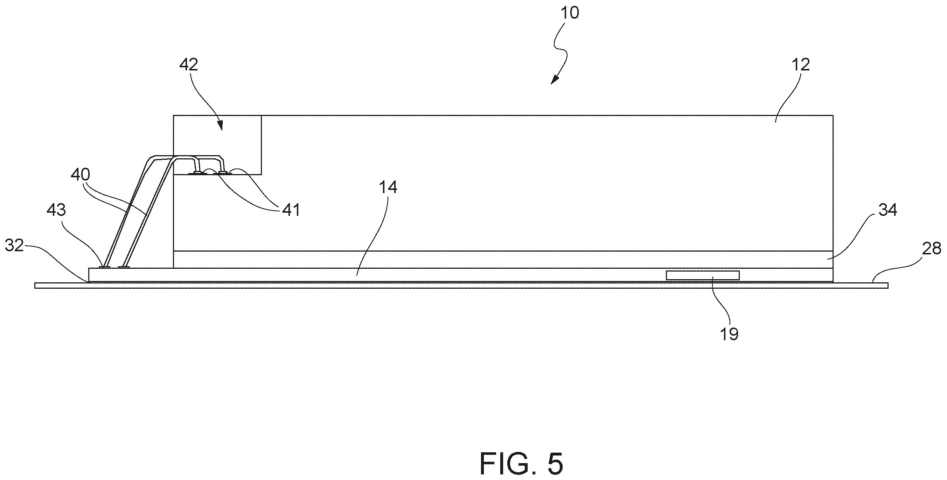

The top mask region 28 is patterned so as to leave the annular region 25 exposed. In greater detail, the annular region 25 surrounds the top mask region 28, at a distance. Furthermore, as visible in Figure 5, the second semiconductive die 14 is fixed to the top mask region 28 by interposing a first attachment region 32 formed for example by adhesive material. Furthermore, the first semiconductive die 12 is arranged above the second semiconductive die 14, to which it is fixed by interposing a second attachment region 34 formed for example by adhesive material.

The first semiconductive die 12 is arranged below the lens 6, to which it is therefore optically coupled, so as to receive the radiation coming from the environment external to the electronic device 1, which is in fact focused by the lens 6 on the first semiconductive die 12, through the hole 11. In a manner known per se, the first semiconductive die 12 forms a thermal transducer, which generates at least one electric detection signal, which is indicative of the radiation, and in particular of the infrared radiation, which impinges on the first semiconductive die 12.

The second die 14 forms an electronic processing circuit 19 of the ASIC type (schematically indicated only in Figure 5) and is electrically coupled to the first semiconductive die 12 by means of a plurality of first wire bondings 40, in such a way that the electronic processing circuit 19 receives the electric detection signal through at least one first wire bonding 40. The electronic processing circuit 19 processes the electric detection signal so as to generate an electric output signal, which is indicative of the presence/absence of (for example) a body (for example, a person) in the environment surrounding the electronic device 1, such body emitting in fact the infrared radiation detected by the first semiconductive die 12.

Without any loss of generality, each first wire bonding 40 connects a corresponding conductive pad 41 arranged in a groove 42 of the first semiconductive die 12 to a corresponding conductive pad 43 arranged on a portion of the second semiconductive die 14 left exposed by the second attachment region 34 and the overlying first semiconductive die 12. The conductive pads 43 are electrically coupled to the electronic processing circuit 19.

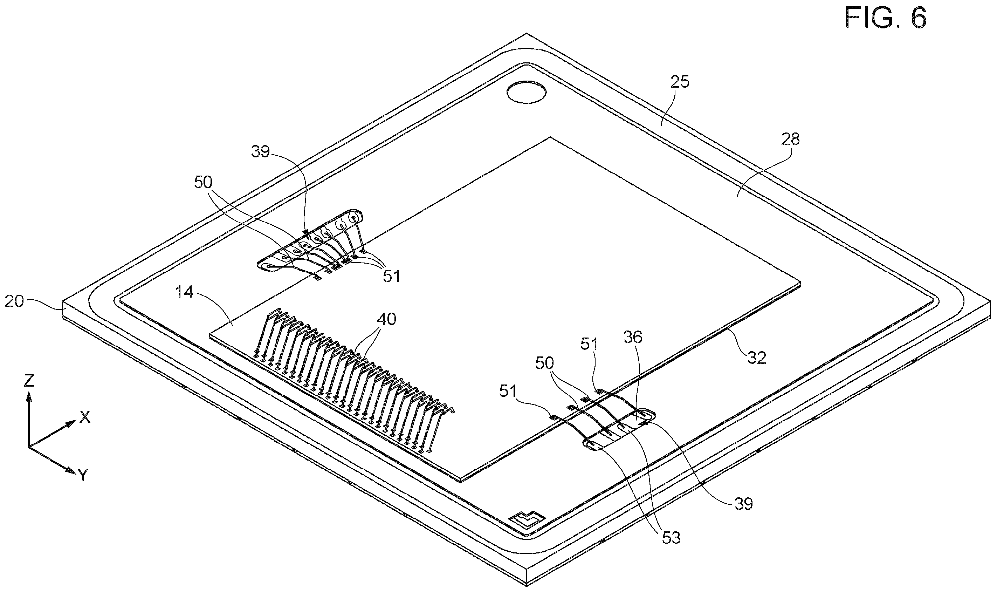

As shown in Figure 6, the top mask region 28 is traversed by a pair of openings 39, which are arranged laterally with respect to the second die 14 and the first attachment region 32. Furthermore, by way of example, the electronic device 1 comprises two groups of second wire bondings 50, each group of second wire bondings 50 extending through a corresponding opening 39. In particular, as explained below, each second wire bonding 50 connects a corresponding conductive pad 51 of the second semiconductive die 14 with a corresponding part of the top metallization 22.

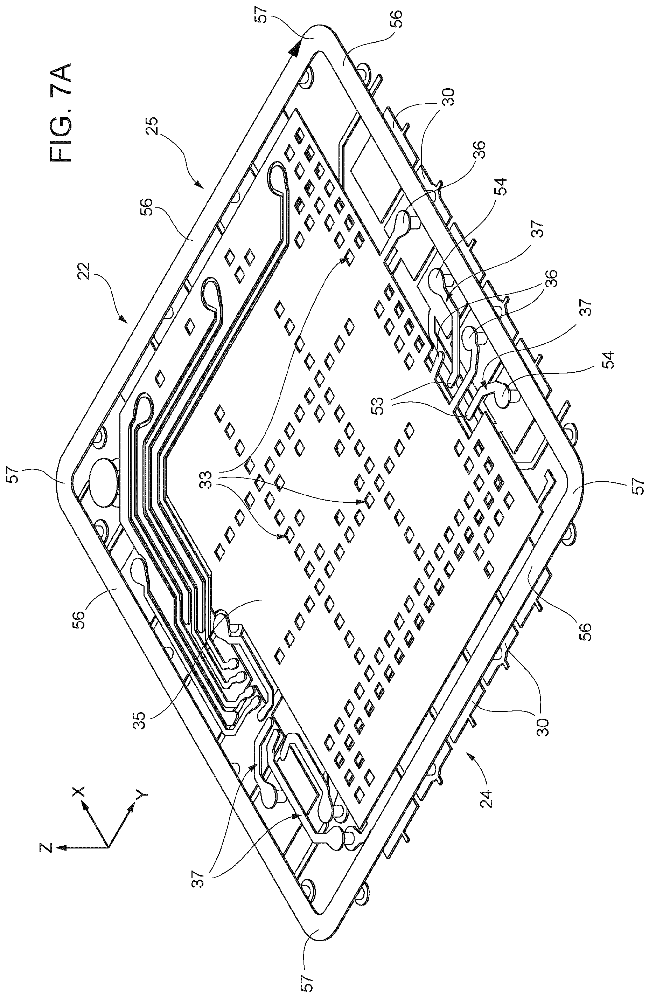

In greater detail, as shown in Figure 7A, the top metallization 22 comprises, in addition to the annular region 25, a central island 35, which has a planar shape parallel to the XY plane and is overlaid by the top mask region 28 and carries the overlying group formed by the first and the second semiconductive dice 12, 14. Without any loss of generality, the central island 35 is traversed by a plurality of through holes 33 (also known as "cut outs"), which are closed by the top mask region 28.

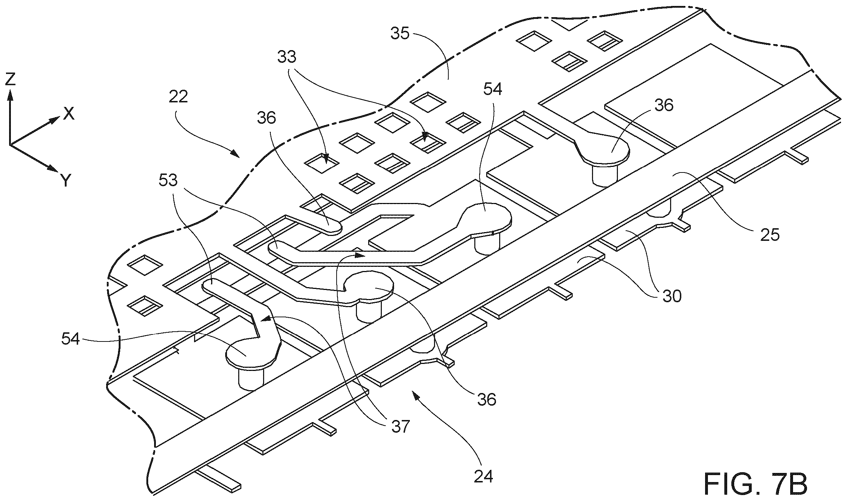

As better visible in Figure 7B, and without any loss of generality, the top metallization 22 also comprises: one or more conductive appendices 36, which have elongated planar shapes that extend laterally starting from the central island 35, to which they are connected; and a plurality of top conductive paths 37, which have elongated planar shapes and are spatially separated from the central island 35.

Even in greater detail, the annular region 25, the central island 35, the conductive appendices 36 and the top conductive paths 37 are coplanar and have approximately a same thickness, for example comprised between 15um and 20um.

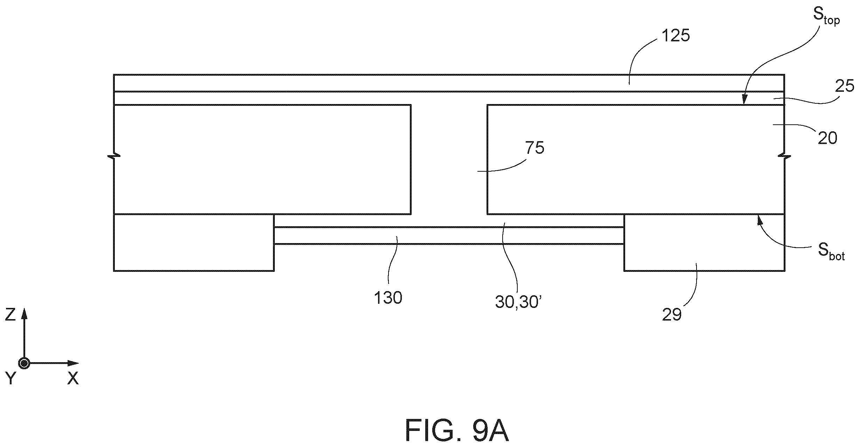

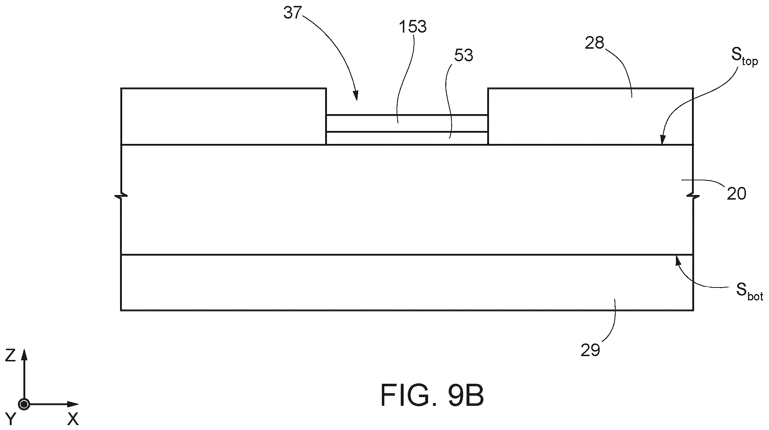

Furthermore, the top conductive paths 37 are only partially covered by the top mask region 28. In particular, a first end 53 of each top conductive path 37 faces a corresponding opening 39; without any loss of generality, in the example shown also conductive appendices 36 are present that face the openings 39. In this regard, as shown only in Figures 9A and 9B, and without any loss of generality, the portions of the top metallization 22 left exposed by the top mask region 28 are plated with a nickel and gold plating.

In particular, as shown in Figure 9A, the annular region 25 is coated upwardly by a plating annular region 125, which, although not shown, is formed by a pair of respective plating layers arranged stacked, formed respectively by nickel and gold, the nickel plating layer being arranged between the annular region 25 and the gold plating layer. Furthermore, as shown in Figure 9B, the first ends 53 of the top conductive paths 37 are plated with respective terminal plating regions 153, also formed by layers of nickel and gold. Furthermore, for each group of second wire bondings 50, each second wire bonding 50 connects the corresponding conductive pad 51 with the terminal plating region 153 that overlies the first end 53 of a corresponding top conductive path 37. Although not shown, the parts of conductive appendices 36 that face the openings 39 are also coated by corresponding plating regions; furthermore, without any loss of generality, second wire bondings 50 may be present which connect the corresponding conductive pads 51 to the plating regions which coat the parts of conductive appendices 36 which face the openings 39.

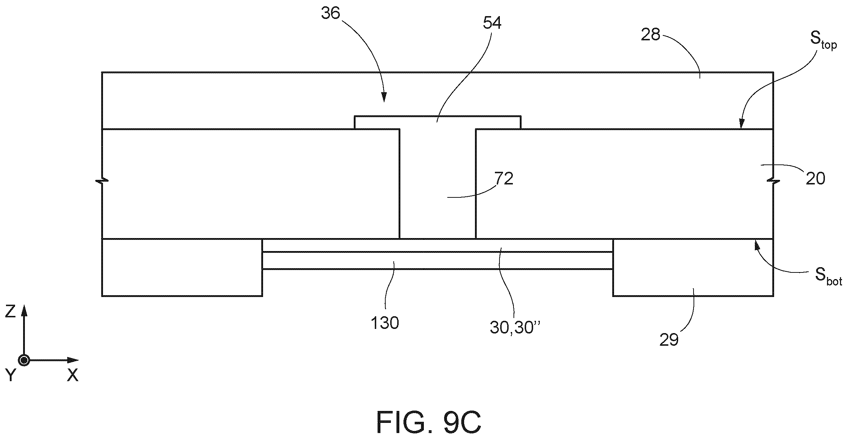

Each top conductive path 37 also comprises a respective second end 54, which is coated upwardly by the top mask region 28, as also visible in Figure 9C. The annular region 25 laterally surrounds the set formed by the central island 35, the conductive appendices 36 and the top conductive paths 37; furthermore, the annular region 25 has for example the shape of a rectangle with beveled vertices, therefore it is formed by four elongated portions 56 and four curved portions 57, the adjacent ends of the pairs of adjacent elongated portions 56 being connected by a corresponding curved portion 57. In addition, each elongated portion 56 overlies, at a distance, a corresponding group of peripheral contacts 30; furthermore, the second end of each top conductive path 37 overlies, at a distance, a corresponding peripheral contact 30.

As shown in Figure 8, the bottom metallization 24 may comprise bottom conductive paths 61, which have elongated planar shapes, parallel to the XY plane, and are coplanar with the central region 26 and with the peripheral contacts 30. Each bottom conductive path 61 may extend between the central region 26 and a corresponding peripheral contact 30 or between two peripheral contacts 30, so as to create a corresponding electric connection. The bottom conductive paths 61 are coated downwardly by the bottom mask region 29. Furthermore, although shown only in Figures 9A and 9C, the peripheral contacts 30 are coated downwardly by corresponding bottom plating regions 130, each of which, although not shown, is formed by a pair of respective plating layers, formed by nickel and gold, respectively, with the nickel plating layer being arranged between the peripheral contact 30 and the gold plating layer. Furthermore, the nine portions of the central region 26 left exposed by the bottom mask region 29 are also coated downwardly by corresponding plating regions, which, however, have been removed in Figure 4, as have the bottom plating regions 130, for clarity reasons.

As shown again in Figure 8, the support structure 2 also comprises different types of conductive vias, which are formed by metal material (for example, copper), extend vertically between the top metallization 22 and the bottom metallization 24, have a cylindrical shape with a diameter comprised for example between 75um and 150um and are for example filled with copper, i.e. they have no cavities therewithin.

In greater detail, the support structure 2 comprises a plurality of internal reference vias 70, each of which has ends integral with the central region 26 and the central island 35, in such a way that, in use, it is grounded, since, in use, the central island 35, the conductive appendices 36 and the central region 26 are grounded.

The support structure 2 further comprises a plurality of peripheral reference vias 71, each of which has ends integral with, respectively, a corresponding conductive appendix 36 and a corresponding peripheral contact 30. In use, each peripheral contact 30 that contacts a corresponding peripheral reference vias 71 and/or is electrically connected to the central region 26 by a corresponding bottom conductive path 61 is connected to ground; hereinafter, the peripheral contacts 30 connected to ground are referred to as ground contacts, which are indicated by 30'. In particular, although not shown, in use the electronic device 1 may be coupled for example to a printed circuit board in such a way that the ground contacts 30' and the central region 26 are connected to the ground of the printed circuit board.

The support structure 2 also comprises a plurality of signal vias 72, each of which has ends integral with, respectively, the second end 54 of a corresponding top conductive path 37 and a corresponding peripheral contact 30. Hereinafter, reference is made to signal contacts 30" to indicate the peripheral contacts 30 connected to the signal vias 72; furthermore, the signal contacts 30" may include peripheral contacts 30 that are not directly connected to corresponding signal vias 72, but are connected through bottom conductive paths 61 to peripheral contacts 30 that are directly connected to corresponding signal vias 72.

Peripheral contacts 30 may also be present that are floating, i.e. are insulated from the ground contacts 30' and from the signal contacts 30" and are intended to remain floating even in use. For the purposes of the operation of the electronic device 1, the possible presence of peripheral contacts 30 that are floating is irrelevant.

The electronic processing circuit 19 provides the electric output signal on at least one of the signal contacts 30", through a corresponding signal via 72, a corresponding top conductive path 37 and a corresponding second wire bonding 50. More generally, the electronic processing circuit 19 may also generate, in a manner known per se, further electric signals, additional with respect to the electric output signal; such further electric signals are also provided on corresponding signal contacts 30", through corresponding signal vias 72 and corresponding second wire bondings 50. One or more signal contacts 30" may also receive corresponding signals from the outside world, for example from the printed circuit board, so as to transfer them to the electronic processing circuit 19, as well as a power supply signal; the transfer occurs through signal vias 72 and corresponding wire bondings 50 not having electrical signals thereon generated by the electronic processing circuit 19.

The electronic device 1 further comprises a plurality of reinforcement vias 75, each of which extends vertically and has ends that are integral with, respectively, the annular region 25 and a corresponding ground contact 30'. In other words, each reinforcement via 75 has a first end that forms a single piece with the annular region 25 and a second end that forms a single piece with the corresponding ground contact 30' .

Without any loss of generality, the reinforcement vias 75 are arranged symmetrically with respect to a first and a second symmetry plane indicated respectively by SP1 and SP2 (shown in Figure 8), which are parallel to the XZ plane and the YZ plane, respectively.

Furthermore, considering each elongated portion 56 of the annular region 25, the reinforcement vias 75 connected to the elongated portion 76 are arranged aligned parallel to the elongated portion 76, hence parallel to the corresponding edge of the bottom surface S_{bot}.

In use, the annular region 25 is connected to ground, thanks to the connections with the ground contacts 30'. Furthermore, the Applicant has observed how the presence of the reinforcement vias 75 allows to reduce the risk of delamination occurring between the annular region 25 and the dielectric substrate 20.

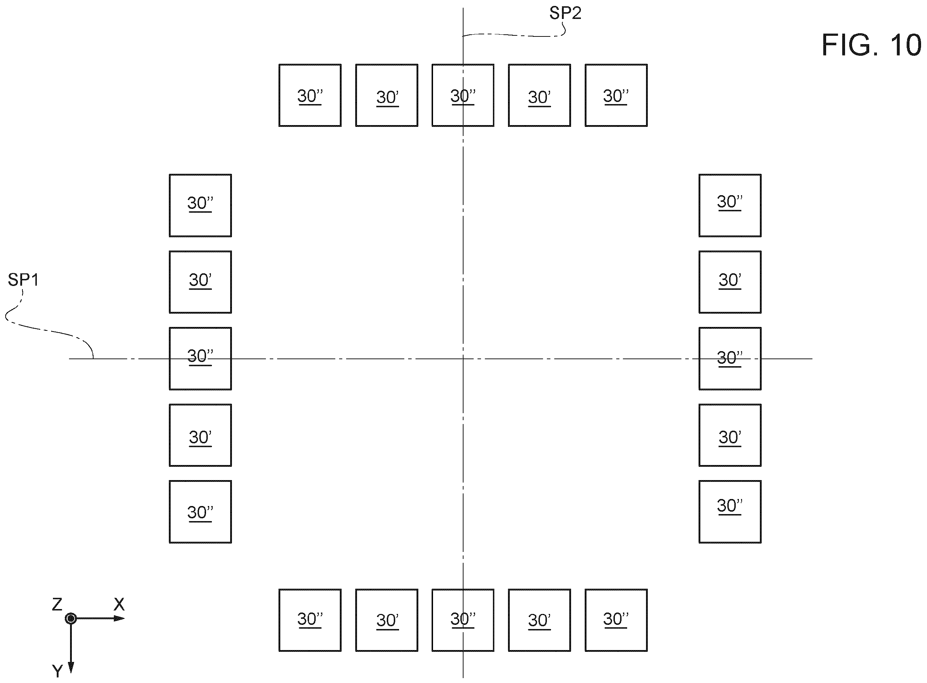

Furthermore, although the arrangement of the ground contacts 30' within the array of peripheral contacts 30 may vary, the resistance to delamination is maximized if the so-called routing of the signals is carried out in such a way that the ground contacts 30' and the signal contacts 30" assume the arrangement shown, more clearly and in principle, in Figure 10. In particular, in each group of peripheral contacts 30, the ground contacts 30' and the signal contacts 30" are arranged alternately; furthermore, optionally, the ground contacts 30' and the signal contacts 30" are arranged symmetrically both with respect to the first symmetry plane SP1 and with respect to the second symmetry plane SP2.

In order to further increase the resistance to delamination, the electronic device 1 may also comprise, for each beveled vertex of the annular region 25, a corresponding pair of further conductive vias 78, which are referred to as the reinforcement angular vias 78. In particular, for each elongated portion 56 of the annular region 25, the two corresponding reinforcement angular vias 78 are arranged on opposite sides of the set of reinforcement vias 75 connected to the elongated portion 76, being aligned therewith, as well as outside the corresponding group of peripheral contacts 30, and have, each, a respective first end which is integral with the elongated portion 76 and a respective second end which is integral with a corresponding pad region 79 placed at a distance from the peripheral contacts 30. The pad regions 79 are part of the bottom metallization 24, therefore they extend below the bottom surface S_{bot}.

In practice, for each elongated portion 76 of the annular region 25, the two corresponding reinforcement angular vias 78 are arranged in proximity to the ends of the elongated portion 76 of the annular region 25. By way of example, considering each elongated portion 76 of the annular region 25, the corresponding reinforcement vias 75 and the corresponding reinforcement angular vias 78 may be arranged uniformly along the direction of the elongated portion 76, i.e. so that adjacent pairs of vias are arranged at a same distance.

The advantages that the present electronic device affords are clear from the preceding description. In particular, the reinforcement vias 75 act as rivets distributed along the annular region 25 and reduce the risk that the delamination of the annular region 25 occurs, without causing an increase in the final dimensions of the electronic device 1.

Furthermore, the electronic device 1 may be manufactured in a simple manner, in particular by first forming the support structure 2, subsequently mechanically and electrically coupling the first and the second dice 12, 14 to the support structure 2 by means of the first and the second attachment regions 32, 34 and the first and the second wire bondings 40, 50, and finally welding or glueing the cap 4 to the plating annular region 125 that overlies the annular region 25, i.e. forming the coupling region 8.

Finally, it is clear that modifications and variations may be made to the electronic device previously described, without departing from the scope of the present invention, as defined in the attached claims.

For example, the dielectric substrate may be formed by a different material, such as for example a ceramic material. The cap may also be formed by a different material, such as for example a plastic material, and may have a different shape with respect to what has been described.

The shape, arrangement and coupling of the first and the second semiconductive dice 12, 14 may differ from what has been described. More generally, the number of dice present in the main cavity 10 may also differ from what has been described; for example, only one semiconductive die may be present.

The shape of the annular region 25 may differ from what has been described. For example, the curved portions 57 may be absent, in which case the elongated portions 56 contact each other.

The central island 35 and the central region 26 may be absent.

Finally, as previously mentioned, the electronic device 1 may be a device other than a TMOS device, such as for example a microphone or a pressure transducer. Consequently, the lens 6 and the hole 11 may be absent.

More generally, the first semiconductive die 12 may translate any chemical or physical quantity into a corresponding electric signal.

## Claims

1. An electronic device comprising:
- a support structure (2) comprising a substrate (20) of dielectric material, a top conductive structure (22), arranged above the substrate (20), and a bottom conductive structure (24), arranged below the substrate (20), the top conductive structure (22) comprising an annular region (25), the bottom conductive structure (24) comprising an array of contacts (30) ;
- a cap (4), which is coupled to the annular region (25) in such a may that the cap (4) and the support structure (2) delimit a cavity (10); and
- at least one semiconductive die (14) arranged in the cavity (10) and configured to generate one or more electric output signals;
and wherein the array of contacts (30) comprises:
- signal contacts (30"), which are electrically coupled to the semiconductive die (14) and are configured to receive, in use, corresponding electric output signals or electric signals generated outside the electronic device (1) and directed towards the semiconductive die (14); and
- reference contacts (30'), which are configured to be set, in use, to a reference potential;
said electronic device (1) further comprising a plurality of reinforcement conductive vias (75), each of which extends through the substrate (20) and has ends fixed respectively to the annular region (25) and to a corresponding reference contact (30').

2. The electronic device according to claim 1, wherein each reinforcement conductive via (75) forms a single piece with the annular region (25) and the corresponding reference contact (30').

3. The electronic device according to claim 1 or 2, wherein the reinforcement conductive vias (75) are arranged symmetrically with respect to at least one of a first and a second symmetry plane (SP1',SP2'), which are perpendicular to each other.

4. The electronic device according to any of the preceding claims, wherein the contacts (30) of the array of contacts (30) are arranged in groups, the contacts (30) of each group being arranged aligned; and wherein, in each group of contacts (30), the respective reference contacts (30') and the respective signal contacts (30") are arranged alternately.

5. The electronic device according to claim 4, wherein the annular region (25) comprises a plurality of elongated portions (56); and wherein each elongated portion (56) of the annular region (25) overlies a corresponding group of contacts (30); said electronic device (1) further comprising, for each elongated portion (56) of the annular region (25), a corresponding pair of additional conductive vias (78), which are arranged on opposite sides of the corresponding group of contacts (30) and have, each, ends fixed respectively to the elongated portion (56) of the annular region (25) and to a corresponding conductive pad (79) arranged below the bottom surface (S_{bot}).

6. The electronic device according to any of the preceding claims, wherein the top conductive structure (22) further comprises a plurality of signal conductive paths (37), said electronic device (1) further comprising:
- a plurality of wire bondings (50), each of which electrically couples the semiconductive die (14) to a respective signal conductive path (37); and
- a plurality of signal conductive vias (72), each of which extends through the substrate (20) and electrically couples a corresponding signal conductive path (37) to a corresponding signal contact (30").

7. The electronic device according to any of the preceding claims, wherein the cap (4) is coupled to the annular region (25) through a bonding or welding region (8).

8. The electronic device according to any of the preceding claims, further comprising a semiconductive transduction die (12), which is configured to transduce a chemical or physical quantity into an electric detection signal; and wherein the semiconductive die (14) is configured to generate at least one of said electric output signals as a function of the electric detection signal.

9. The electronic device according to claim 8, wherein the cap (4) includes a hole (11); and wherein the semiconductive transduction die (12) is configured to receive, through the hole (11), radiation coming from outside the electronic device (1) and to transduce the received radiation into the electric detection signal; and wherein the semiconductive die (14) is configured in such a way that at least one of said electric output signals is indicative of the presence/absence, outside the electronic device (9), of a body that emits radiation.

10. A process for manufacturing an electronic device (1), comprising:
- forming a support structure (2) comprising a substrate (20) of dielectric material, a top conductive structure (22), arranged above the substrate (20), and a bottom conductive structure (24), arranged below the substrate (20), the top conductive structure (22) comprising an annular region (25), the bottom conductive structure (24) comprising an array of contacts (30) ;
- coupling a cap (4) to the annular region (25) in such a way that the cap (4) and the support structure (2) delimit a cavity (10); and
- arranging in the cavity (10) at least one semiconductive die (14) configured to generate one or more electric output signals;
and wherein the array of contacts (30) comprises:
- signal contacts (30"), which are electrically coupled to the semiconductive die (14) and are configured to receive, in use, corresponding electric output signals or electric signals generated outside the electronic device (1) and directed towards the semiconductive die (14); and
- reference contacts (30'), which are configured to be set, in use, to a reference potential;
said manufacturing process further comprising forming a plurality of reinforcement conductive vias (75), each of which extends through the substrate (20) and has ends fixed respectively to the annular region (25) and to a corresponding reference contact (30').
